# EUROPÄISCHE PATENTSCHRIFT

(11) **EP 1 557 492 B1**
(45) Veröffentlichungstag und Bekanntmachung des Hinweises auf die Patenterteilung: **15.12.2010**
(21) Anmeldenummer: 04025454.2
(22) Anmeldetag: 26.10.2004
(51) Int. Cl.: E01C 19/48, H05B 1/02, G01R 19/145, G08B 5/22

(54) **Vorrichtung zur Funktionsüberwachung**
Apparatus for function monitoring
Appareil pour surveiller un fonctionnement

(30) Priorität: 22.01.2004 DE 102004003356
(43) Veröffentlichungstag der Anmeldung: 27.07.2005
(73) Patentinhaber: Joseph Voegele AG, 68146 Mannheim (DE)
(72) Erfinder: Buschmann, Martin, 67435 Neustadt a.d.W. (DE)
(74) Vertreter: Grünecker, Kinkeldey, Stockmair & Schwanhäusser Anwaltssozietät

(56) Entgegenhaltungen:
- EP-A2- 1 036 883
- DE-A1- 2 264 357
- DE-A1- 19 537 691
- DE-A1- 19 702 922
- DE-C1- 4 026 894
- US-B1- 6 334 735

## Beschreibung

Die Erfindung bezieht sich auf einen Straßenfertiger, der im Oberbegriff von Anspruch 1 erläuterten Art.

Ein derartiger Straßenfertiger ist aus der EP 1 036 883 bekannt. Der bekannte Straßenfertiger enthält eine elektrische Heizeinrichtung zum Beheizen einer Einbaubohle. Die Heizeinrichtung wird über einen Drehstromgenerator mit Strom beliefert, wobei am Ausgang des Drehstromgenerators eine Stromüberwachung zur Leistungssteuerung vorgesehen ist. Die Stromüberwachung ist ein Stromwandler, der den aktuellen Stromwert einer der drei Phasen des Drehstromgenerators einer Mikroprozessor-Management-Sektion meldet. Mit dem bekannten Stromwandler ist somit nur der Ausgang des Drehstromgenerators zu überwachen.

Es sind weiterhin Überwachungseinrichtungen für elektrische Verbraucher bekannt, beispielsweise aus der DE-A-19 702 922 oder der DE-A-4 026 894, die eine Induktionsspule einsetzen. Eine spezielle Anordnung dieser Induktionsspulen bei Straßenfertigem wird jedoch nicht beschrieben.

Straßenfertiger weisen eine Vielzahl von Heizelementen und Heizeinrichtungen auf, die die unterschiedlichsten Arbeitskomponenten, die mit dem erhitzten Einbaumaterial zum Herstellen von Fahrbahndecken in Berührung kommen, beheizen, um einerseits ein verfrühtes Abkühlen des Einbaumaterials zu verhindem und um andererseits zu verhindem, dass Einbaumaterial an kalten Flächen der jeweiligen Arbeitskomponente erstarrt und dort haften bleibt. Diese Heizeinrichtungen müssen überwacht werden, um auf jeden Fall sicherzustellen, dass die vorbestimmte Temperatur der Arbeitskomponente erreicht und aufrechterhalten wird. So zeigt beispielsweise die US-B-6 334 735 ein automatisch gesteuertes Heizsystem für einen Straßenfertiger, bei dem ein Steuersystem verwendet wird, das automatisch den Stromfluss durch das Heizelement einstellt, um die Temperatur zu regulieren. Zum Überwachen der Heizeinrichtung und der von ihr erzeugten Temperatur wird wenigstens ein Temperatursensor verwendet. Ein Temperatursensor, zumindest wenn er in der beschriebenen Weise eingesetzt wird, ist jedoch nur unvollkommen in der Lage, jede einzelne Heizeinrichtung, insbesondere jeden einzelnen Heizstab in einer Heizeinrichtung daraufhin zu überwachen, ob dieser defekt ist oder korrekt arbeitet. Es kann immer nur festgestellt werden, ob die Heizeinrichtung als Ganzes in der Lage ist, die gewünschte Temperatur zu erreichen und zu halten.

Es würde jedoch die Reparatur einer defekten Heizeinrichtung stark vereinfachen, wenn sofort festgestellt werden könnte, dass einer der Heizstäbe defekt ist und welcher dies ist.

Der Erfindung liegt somit die Aufgabe zugrunde, einen Straßenfertiger mit einer Vorrichtung zur Funktionsüberwachung einer elektrischen Heizung einer Einbaubohle bereitzustellen, die auf einfache, kostengünstige und sichere Weise eine Überwachung der Einbaubohle gestattet.

Die Aufgabe wird durch die im Anspruch 1 angegebenen Merkmale gelöst.

Durch die erfindungsgemäße Ausgestaltung ist es ohne großen Kostenaufwand möglich, in jeder Heizeinrichtung festzustellen, ob dort Strom fließt. Induktionsspulen sind einfach vorzusehen, einzubauen und robust im Betrieb, so dass damit eine sichere Funktionsüberwachung gegeben ist.

Vorteilhafte Weiterbildungen der Erfindung sind den Unteransprüchen zu entnehmen.

Besonders zweckmäßig ist es, wenn für die Anzeige eine Leuchtdiode verwendet wird, die in Verbindung mit der Induktionsspule ein passives System ohne eigene Versorgungsspannung bildet.

Zusammen mit einer Gleichrichterschaltung eignet sich die erfindungsgemäße Vorrichtung mit Induktionsspule und Leuchtdiode auch für Verbraucher, die mit Wechseloder Drehstrom betrieben werden.

Durch eine mit der Induktionsspule verbundene Messeinrichtung können weiterhin genaue Messdaten gewonnen und direkt oder in verarbeitender Form angezeigt werden.

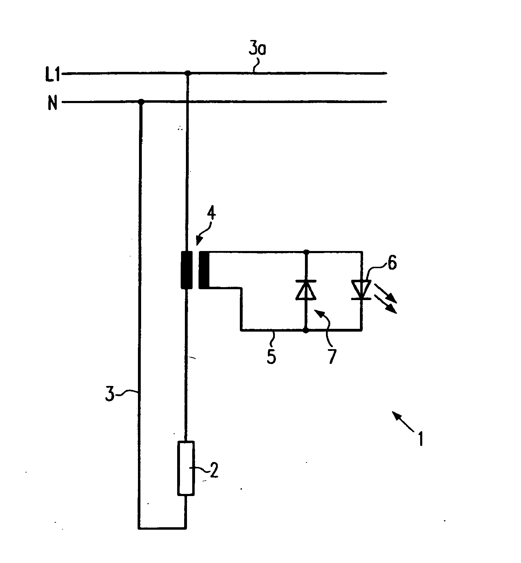

Ein Ausführungsbeispiel der Erfindung wird nachfolgend anhand der einzigen Zeichnung näher erläutert, die ein Schaltbild einer erfindungsgemäßen Vorrichtung zeigt.

Die Figur zeigt eine nur schematisch angedeutete Vorrichtung 1 zur Funktionsüberwachung einer elektrischen Heizeinrichtung 2, die über einen Versorgungsstromkreis 3 (230V) mit elektrischer Energie versorgt wird. Hierbei handelt es sich um ein einzelnes Heizelement oder einen Heizstab innerhalb eines Heizstromkreises 3a zum Beheizen von Arbeitskomponenten eines Straßenfertigers, also zum Beheizen der verschiedenen Teile einer Einbaubohle oder dgl. Der Heizeinrichtung 2 ist eine einfache Einrichtung zur Strom-/Spannungsmessung zugeordnet, die als Induktionsspule 4 ausgebildet ist. Die Induktionsspule 4 ist direkt in den Versorgungsstromkreis 3 integriert. Die Induktionsspule 4 versorgt einen Anzeigestromkreis 5 mit elektrischer Energie, in dem eine Einrichtung zum Feststellen und Anzeigen eines Stromflusses in Form einer Leuchtdiode 6 angeordnet ist. Fließt somit im Versorgungsstromkreis 3 ein Strom, so leuchtet die Leuchtdiode 6. Wenn im Versorgungsstromkreis 3 Wechsel- oder Drehstrom fließt, wie dies bei Heizeinrichtungen in Straßenfertigern die Regel ist, enthält der Anzeigenstromkreis 5 eine Gleichrichterschaltung 7 mit einer weiteren, entgegengesetzt geschalteten Diode oder einem Widerstand für die zweite Halbwelle.

Im Betrieb wird in der Spule 4 durch die Wechselspannung im Versorgungsstromkreis 3 und/oder im Bereich des Heizdrahtes der Heizeinrichtung 2 eine Spannung induziert und in einer Einrichtung, beispielsweise der dargestellten LED 6 in ein Signal umgesetzt, d.h. die LED 6 leuchtet. Kommt es zu einer Unterbrechung der Stromzufuhr, fällt der Induktionseffekt weg und die Anzeige, beispielsweise die LED, erlischt.

Ergänzend könnte die erfindungsgemäße Vorrichtung 1 auch über eine Schaltung verfügen, die unterschiedlich hohe Spannungen/Ströme auswerten kann.

Es ist weiterhin möglich, eine Messeinrichtung vorzusehen, mit der ein Stromfluss nicht nur festgestellt, sondern gemessen wird, wobei die Messdaten, entweder direkt angezeigt oder, wie auch die einfachen Ja- oder Nein-Signale, zu Befehlen (z.B. "Heizung X defekt") oder anderen Anzeigesignalen verarbeitet werden können.

In Abwandlung des beschriebenen und gezeichneten Ausführungsbeispiels können andere geeignete Einrichtungen zum Feststellen und Anzeigen eines Stromflusses, vorzugsweise solche, die keine zusätzliche Versorgungsspannung benötigen, eingesetzt werden.

Die Anschlusszuleitung für einen Heizstab erfolgt in der Regel von einem Klemmenkasten auf der Einbaubohle eines Straßenfertigers. Dabei wird die Zuleitung am Klemmenkasten durch eine Kabelverschraubung geführt. Diese Kabelverschraubung ist als Induktionsspule mit einer Einrichtung zum Feststellen und Anzeigen eines Stromflusses, z.B. einer Leuchtdiode, ausgebildet .

## Patentansprüche

1. Straßenfertiger mit wenigstens einer in einem Versorgungsstromkreis (3) geschalteten, elektrischen Heizeinrichtung (2) mit einem Heizstromkreis (3a) zum Beheizen einer Einbaubohle, und einer Vorrichtung (1) zur Funktionsüberwachung der Heizeinrichtung (2) , **dadurch gekennzeichnet dass** die Vorrichtung (1) eine der Heizeinrichtung (2) zugeordnete und direkt in den Versorgungsstromkreis (3) integrierte Induktionsspule (4) enthält, die mit einer Einrichtung (6) zum Feststellen und Anzeigen einer durch den Versorgungsstrom in der Spule (4) induzierten Spannung verbunden ist, wobei die Induktionsspule (4) als Kabelverschraubung an einem Klemmenkasten der Einbaubohle ausgebildet ist, durch die die Heizstromkreis-Leitung geführt ist.

2. Straßenfertiger nach Anspruch 1, **dadurch gekennzeichnet, dass** die Einrichtung (6) eine visuelle Anzeige enthält.

3. Straßenfertiger nach Anspruch 1 oder 2, **dadurch gekennzeichnet, dass** die Einrichtung (6) eine Leuchtdiode enthält.

4. Straßenfertiger nach Anspruch 3, **dadurch gekennzeichnet, dass** bei einem mit Wechsel- oder Drehstrom betriebenen elektrischen Verbraucher die Leuchtdiode (6) in einer Gleichrichterschaltung (7) geschaltet ist.

5. Straßenfertiger nach einem der Ansprüche 1 bis 4, **dadurch gekennzeichnet, dass** die Einrichtung (6) ein Messgerät enthält.

## Claims

1. A road finisher comprising at least one electric heating unit (2) connected in a supply circuit (3) having a heating circuit (3a) for heating a paving screed, and a device (1) for supervising the function of the heating unit (2), **characterized in that** said device (1) comprises an induction coil (4) which is associated with the heating unit (2) and which is directly integrated into the supply circuit (3), said induction coil (4) being connected to means (6) for detecting and indicating a voltage induced in the coil (4) by the supply current and being implemented as a screwed cable gland on a terminal box of the paving screed through which the lead of the heating circuit extends.

2. A device according to claim 1, **characterized in that** said means (6) comprise a visual indicator.

3. A device according to claim 1, **characterized in that** said means (6) comprise a light emitting diode.

4. A device according to claim 3, **characterized in that**, if the electric consumer is operated with alternating current or with a three-phase current, the light emitting diode (6) is connected in a rectifier circuit (7).

5. A device according to any one of claims 1 to 4, **characterized in that** said means (6) comprise a measuring instrument.

## Revendications

1. Finisseur de routes avec au moins un dispositif de chauffage (2) électrique branché dans un circuit de courant d'alimentation (3) et comprenant un circuit de courant de chauffage (3a) pour chauffer une table de pose et avec un dispositif (1) pour surveiller le fonctionnement du dispositif de chauffage (2), **caractérisé en ce que** le dispositif (1) contient une bobine d'induction (4) qui est associée au dispositif de chauffage (2) et directement intégrée dans le circuit de courant d'alimentation (3) et qui est reliée à un dispositif (6) pour la détermination et l'indication d'une tension induite par le courant d'alimentation dans la bobine (4), la bobine d'induction (4) étant conçue comme un passe-câble à vis sur une boîte de connexions de la table de pose, passe-câble à travers lequel est guidé le conducteur de circuit de courant de chauffage.

2. Finisseur de routes selon la revendication 1, **caractérisé en ce que** le dispositif (6) contient un indicateur visuel.

3. Finisseur de routes selon la revendication 1 ou 2, **caractérisé en ce que** le dispositif (6) contient une diode électroluminescente.

4. Finisseur de routes selon la revendication 3, **caractérisé en ce que**, dans le cas d'un consommateur d'énergie électrique utilisant du courant alternatif ou du courant triphasé, la diode électroluminescente (6) est branchée dans un circuit redresseur (7).

5. Finisseur de routes selon l'une des revendications 1 à 4, **caractérisé en ce que** le dispositif (6) contient un appareil de mesure.
